# EUROPÄISCHE PATENTSCHRIFT

(11) **EP 0 355 501 B1**
(45) Veröffentlichungstag und Bekanntmachung des Hinweises auf die Patenterteilung: **16.02.1994**
(21) Anmeldenummer: 89114215.0
(22) Anmeldetag: 01.08.1989
(51) Int. Cl.: H01L 27/02, H02H 9/04

(54) **Bipolartransistor als Schutzelement für integrierte Schaltungen**
Bipolar transistor as protection device for integrated circuits
Transistor bipolaire comme élément de protection pour circuits intégrés

(30) Priorität: 16.08.1988 DE 3827801
(43) Veröffentlichungstag der Anmeldung: 28.02.1990
(73) Patentinhaber: SIEMENS AKTIENGESELLSCHAFT, 80333 München (DE)
(72) Erfinder: Winnerl, Josef, Dr.-Ing., D-8300 Landshut (DE); Guggenmos, Xaver, Dipl.-Ing., D-8000 München 60 (DE)

(56) Entgegenhaltungen:
- EP-A- 0 057 024
- EP-A- 0 168 678
- PATENT ABSTRACTS OF JAPAN vol. 12, no. 7 (E-571)(2854) 09 Januar 1988 ; & JP-A-62 165969

## Beschreibung

Die Erfindung bezieht sich auf einen Bipolartransistor als Schutzelement gegen elektrische Überspannungen für integrierte Schaltungen nach dem Oberbegriff des Patentanspruchs 1 oder nach dem gleichlautenden Oberbegriff des Patentanspruchs 3.

Integrierte Schaltungen sind sowohl während des Betriebs als auch vor dem Einbau elektrischen Überspannungen ausgesetzt. MOS-Transistoren sind hierbei besonders gefährdet, da aufgrund der geringen Kapazität und des hohen Isolationswiderstandes des MOS-Gates bereits eine geringe Ladungsmenge eine hohe Spannung aufweist, die zum Durchbruch des Oxids führt. Aus diesem Grunde werden insbesondere bei MOS- und CMOS-Schaltungen die Anschlüsse der Ein- und Ausgänge der Schaltung durch integrierte Schutzstrukturen vor Überspannungen geschützt.

Integrierte Schutzstrukturen funktionieren nach dem Prinzip, elektrische Überspannungen über einen niederohmigen Strompfad eines sog. Klemmelements gegen V_{DD} (Versorgungsspannung) bzw. V_{SS} (Masse) abzubauen. Als Klemmelemente können hierbei Dioden, MOS-Transistoren, parasitäre Bipolartransistoren oder andere Halbleiterbauelemente verwendet werden. Zur Herstellung einer Eingangsschutzstruktur werden nach dem Stand der Technik zwei Klemmelemente mit einem zwischengeschalteten Serienwiderstand benötigt. Der Serienwiderstand begrenzt den Strom des zweiten Klemmelements und stellt zusammen mit diesem eine Spannungsteilerschaltung dar, die die auftretenden Überspannungen auf unkritische Werte begrenzt. Im Betriebsspannungsbereich müssen die Klemmelemente hochohmig sein und sie sollen für Überspannungen einen niedrigen differentiellen Widerstand besitzen. Integrierte Schutzstrukturen und Klemmelemente sind beispielsweise in der Veröffentlichung C. Duvvury et al, EOS/ESD Symp. Proc. 1983, S. 191 und in der Veröffentlichung J. K. Keller, EOS/ESD Symp. Proc., 1980, auf S. 73 angegeben. Die bei den MOS- und CMOS-Schutzstrukturen als Klemmelemente verwendeten Bauelemente haben den Nachteil, daß immer Diffusionsgebiete im Substrat oder in der Wanne vorhanden sind, die direkt über den pn-Übergang bzw. über einen parasitären Bipolartransistor Substratströme erzeugen können. Im Betrieb auftretende Substratströme können in CMOS-Schaltungen Latch-Up auslösen und stellen daher ein großes Sicherheitsrisiko dar. Aus der Literatur sind keine Schutzstrukturen in CMOS-Technologie bekannt, die dieses Problem vermeiden.

Zum Verständnis des Latch-Up-Effekts kann man davon ausgehen, daß zwischen einem Anschluß eines in der wannenförmigen Halbleiterzone liegenden Feldeffekttransistors des ersten Kanaltyps und einen Anschluß eines außerhalb dieser Zone auf dem Halbleitersubstrat plazierten Feldeffekttransistors des zweiten Kanaltyps im allgemeinen vier aufeinanderfolgende Halbleiterschichten alternierender Leitfähigkeiten vorhanden sind, wobei das eine Anschlußgebiet des erstgenannten Transistors die erste Halbleiterschicht, die wannenförmige Halbleiterzone die zweite, das Halbleitersubstrat die dritte und das eine Anschlußgebiet des letzten Transistors die vierte Halbleiterschicht bilden. Aufgrund dieses Aufbaus ergeben sich ein parasitäter bipolarer pnp- und ein npn-Transistor. Der Kollektor des pnp-Transistors entspricht der Basis des npn-Transistors und die Basis des pnp-Transistors dem Kollektor des npn-Transistors. Diese Struktur bildet eine Vierschichtdiode pnpn wie bei einem Thyristor. Bei einer positiven Vorspannung des Halbleitersubstrats kann der pn-Übergang zwischen der dritten und vierten Halbleiterschicht so weit in Durchlaßrichtung vorgespannt werden, daß zwischen den genannten Transistoranschlüssen ein Strompfad entsteht, der auf einer parasitären Thyristorwirkung innerhalb dieser Vierschichtstruktur zurückzuführen ist. Dieser Strompfad kann hierbei die integrierte Schaltung thermisch überlasten und im weiteren zur Zerstörung der integrierten Schaltung führen.

Aus den Patent Abstracts of Japan 12(7), (E-571) 2854 und der japanischen Anmeldeschrift JP-A-62-165969 (Sanyo Electric) ist der Schutz von CMOS-Schaltungsein- bzw. ausgängen mit Hilfe von Bipolartransistoren bekannt, wobei beispielsweise der Emitter des Bipolartransistors mit dem CMOS-Schaltungsein- bzw. ausgang, der Kollektor mit der Versorgungsspannung und die Basis mit Bezugspotential verbunden sind.

Aus EP-A-0 057 024 ist ein Bipolartransistor als Schutzelement bekannt, wobei durch einen zwischen dem Emitter- und Kollektoranschluß angeordneten Gateanschluß ein MOS-Feldeffekttransistor entsteht.

Der Erfindung liegt die Aufgabe zugrunde, eine möglichst einfache Schutzstruktur mit Hilfe eines Bipolartransistors als Schutzelement anzugeben, bei der die integrierte Schaltung an den Ein- und Ausgängen vor elektrischen Überspannungen besser als beim Gegenstand der obengenannten japanischen Anmeldeschrift 62-165969 geschützt und hierbei kein "Latch-Up" auslösender Substratstrom erzeugt werden soll.

Diese Aufgabe wird erfindungsgemäß durch die Ausbildung der Schaltung nach dem kennzeichnenden Teil des Patentanspruchs 1 erreicht.

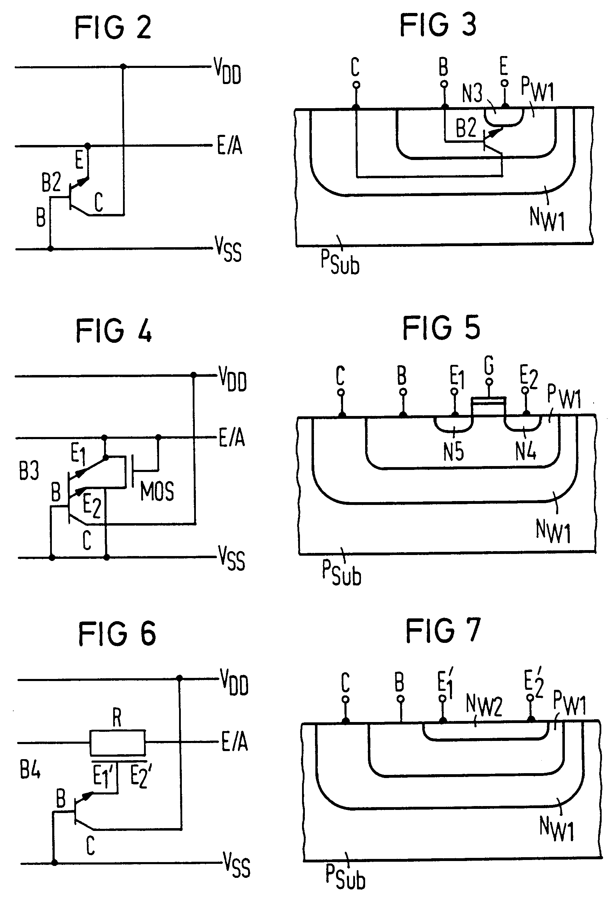

Die Patentansprüche 2 und 4 bis 6 sind auf eine bevorzugte Ausgestaltung und Weiterbildung der Erfindung gerichtet. Der mit der Erfindung erzielbare Vorteil liegt insbesondere darin, daß zur Realisierung einer Eingangsschutzstruktur lediglich ein Halbleiterbauelement benötigt wird, wobei dieses sowohl in einer MOS- oder CMOS- als auch in einer kombinierten Bipolar/CMOS-Technologie eingesetzt werden kann. Ebenso ist das Halbleiterbauelement auch in einer anderen Halbleitertechnologie einsetzbar und schützt die integrierte Schaltung vor positiven und negativen Überspannungen. Drei Ausführungsbeispiele der Erfindung sowie deren Realisierungsmöglichkeiten sind in den Figuren 2 bis 7 dargestellt und werden im folgenden näher beschrieben. Es zeigen:
- Figur 1: ein Klemmelement nach dem Stand der Technik,
- Figur 2 und 3: eine bekannte Verschaltung und eine Realisierungsmöglichkeit eines Bipolartransistors als Schutzelement für integrierte Schaltungen,
- Figur 4 und 5: eine erste erfindungsgemäße Verschaltung eines Bipolartransistors mit zwei Emittern und einem zusätzlichen MOS-Transistor sowie eine passende Realisierungsmöglichkeit,
- Figur 6 und 7: eine zweite erfindungsgemäße Verschaltung des Bipolartransistors mit einem integrierten Serienwiderstand, sowie eine zugehörige Realisierungsmöglichkeit.

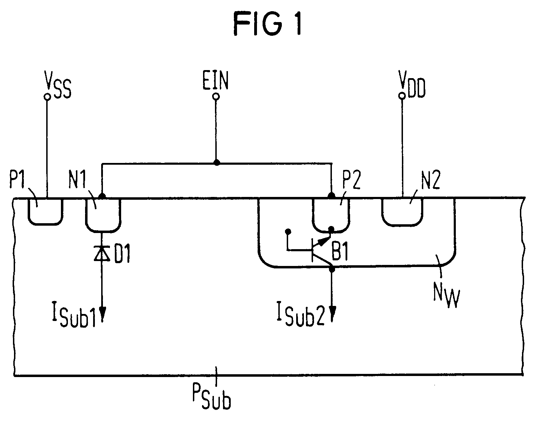

Figur 1 zeigt ein Klemmelement nach dem Stand der Technik, bestehend aus einer Diode D1 und einem Bipolartransistor B1. Jeweils zwei solcher Klemmelemente gemeinsam mit einem Widerstand, welcher zwischen dem Eingang EIN eines ersten und dem Eingang eines zweiten Klemmelements geschaltet ist, ergeben eine Eingangsschutzstruktur. Eine zu schützende Eingangs- bzw. Ausgangsleitung wird an einer geeigneten Stelle aufgetrennt und der Widerstand wird mit seinen beiden Anschlüssen in die aufgetrennte Eingangs- bzw. Ausgangsleitung geschaltet. Der Widerstand begrenzt, wie bereits eingangs angegeben, den Strom des zweiten Klemmelements und stellt zusammen mit diesem eine Spannungsteilerschaltung dar, die die auftretenden Überspannungen auf unkritische Werte begrenzt. Das Klemmelement ist innerhalb eines p-dotierten Substrats P_{Sub} aufgebaut, wobei ein erster p⁺-dotierter Anschluß P1 mit der Masse V_{SS} verbunden ist. Die Diode D1, die in Figur 1 zur besseren Darstellung mit ihrem Schaltsymbol wiedergegeben ist, schützt die Eingangs- bzw. Ausgangsleitung vor negativen Überspannungen. Hierzu ist die Kathodenseite der Diode D1 durch einen zweiten n⁺-dotierten Anschluß N1 innerhalb des p-dotierten Substrats P_{Sub} realisiert, während als Anodenanschluß der Diode D1 das p-dotierte Substrat P_{Sub} benutzt wird. Figur 1 zeigt weiter eine n-leitende wannenförmige Halbleiterzone N_{W} innerhalb des Halbleitersubstrats P_{Sub}, die über einen dritten n⁺-dotierten Anschluß N2 mit der Versorgungsspannung V_{DD} beschaltet ist. Zusätzlich zu diesem dritten Anschluß N2 weist die n-leitende wannenförmige Halbleiterzone N_{W} einen vierten p⁺-dotierten Anschluß P2 auf, wobei der zuletzt genannte vierte Anschluß P2 gemeinsam mit der n-leitenden wannenförmigen Halbleiterzone N_{W} in dem p-dotierten Halbleitersubstrat P_{Sub} einen bipolaren pnp-Transistor B1 bilden. Dieser bipolare pnp-Transistor B1 ist bei positiven Überspannungen wirksam und leitet diese über das Halbleitersubstrat P_{Sub} ab. Ebenso wie die Diode D1 ist der bipolare pnp-Transistor P1 zur besseren Darstellung in Figur 1 mit seinem Schaltsymbol wiedergegeben. Beide Elemente, sowohl die Diode D1 als auch der bipolare pnp-Transistor P1, sind einseitig, für die Diode D1 über den zweiten Anschluß N1 und für den bipolaren Transistor B1 über den vierten Anschluß P2, mit einem gemeinsamen Eingang EIN des Klemmelements verbunden. Beide verwendeten Bauteile haben den Nachteil, daß immer Diffusionsgebiete im Halbleitersubstrat P_{Sub} oder in der wannenförmigen Halbleiterzone N_{W} vorhanden sind, die direkt über den pn-Übergang bzw. über einen parasitären Bipolartransistor Substratströme erzeugen können. Im Betrieb auftretende Substratströme können jedoch, wie ebenfalls eingangs erwähnt, in CMOS-Schaltungen einen "Latch-Up" auslösen und stellen daher ein großes Sicherheitsrisiko für die integrierte Schaltung dar.

Figur 2 zeigt einen bekannt verschalteten Bipolartransistor B2 als Klemmelement, der, wie aus der Querschnittszeichnung nach Figur 3 hervorgeht, isoliert zum p-dotierten Halbleitersubstrat P_{Sub} angeordnet ist. Der isolierte npn-Bipolartransistor B2 ist so verschaltet, daß der Emitter E mit dem Ein- bzw. Ausgang E/A verbunden ist und die Basis B auf einem Bezugspotential (bei npn-Transistoren auf V_{SS} = Masse) liegt. Der Kollektor C des npn-Bipolartransistor B2 wird vorzugsweise an eine, in diesem Falle positive, Versorgungsspannung V_{DD} angeschlossen. Figur 3 zeigt, wie der bipolare npn-Transistor B2 innerhalb des p-leitenden Halbleitersubstrats P_{Sub} eingefügt ist. Zur besseren Verdeutlichung ist in Figur 3 ebenfalls der Bipolartransistor B2 als Schaltsymbol mit seinem Kollektoranschluß C, Basisanschluß B und Emitteranschluß E wiedergegeben. Eine erste wannenförmige Halbleiterzone N_{W1}, die n-dotiert ist, und innerhalb des p-leitenden Halbleitersubstrats P_{Sub} eingefügt ist, bildet den Kollektoranschluß C und stellt gemeinsam mit dem p-dotierten Halbleitersubstrat P_{Sub} einen isolierenden pn-Übergang dar. Innerhalb dieser ersten wannenförmigen Halbleiterzone N_{W1} ist eine zweite wannenförmige Halbleiterzone P_{W1} aufgebracht, welche p-dotiert ist, und den Basisanschluß B des bipolaren npn-Transistors B2 bildet. Schließlich ist noch der Emitter E über einen n⁺-dotierten Anschluß N3 innerhalb der zweiten wannenförmigen Halbleiterzone P_{W1} untergebracht.

Im folgenden nun soll die Funktion des als Klemmelement eingesetzten bipolaren npn-Transistors B2 in Betrieb erklärt werden. Bei pnp-Bipolartransistoren sind die Polaritäten der Spannungen jeweils zu vertauschen. Wird die Spannung auf der Ein- bzw. Ausgangsleitung E/A und damit am Emitter E negativer als das Bezugspotential V_{SS}, so wird der Bipolartransistor B2 in Vorwärtsrichtung betrieben und ein Emitterstrom fließt als Kollektorstrom ab. Hierbei ist das p-dotierte Halbleitersubstrat P_{Sub} durch den pn-Übergang zwischen der n-leitenden wannenförmigen Halbleiterzone N_{W1} und dem p-leitenden Halbleitersubstrat P_{Sub} elektrisch isoliert und es kann kein Substratstrom fließen. Erst wenn der bipolare npn-Transistor B2 aufgrund des Spannungsabfalls am Kollektorbahnwiderstand der wannenförmigen Halbleiterzone N_{W1} in der Sättigung betrieben würde, entstünde ein Substratstromanteil. Dies kann durch geeignete Dimensionierung der Transistorgrößen vermieden werden. Wird hingegen die Spannung am Emitter E des bipolaren npn-Transistors B2 und damit am Ein-bzw. Ausgang E/A der zu schützenden integrierten Schaltung positiver als das Basispotential an dem Basisanschluß B und somit positiver als das Bezugspotential V_{SS}, kann erst dann ein Strom fließen, wenn die Emitter/Basisdurchbruchsspannung erreicht wird. Der hierbei auftretende Emitterstrom fließt über den Basisanschluß B ab, wobei die Basis selbst durch die n-leitende wannenförmige Halbleiterzone N_{W1} vom Substrat isoliert ist. Erst wenn der Spannungsabfall am Basisbahnwiderstand innerhalb der p-leitenden wannenförmigen Halbleiterzone P_{W1} größer als die der Versorgungsspannung V_{DD} wird, leitet der parasitäre Bipolartransistor, der zwischen dem Basisanschluß B, dem Kollektoranschluß C und dem p-dotierten Halbleitersubstrat P_{Sub} vorhanden ist und es entsteht ein Substratstrom. Die Emitter-Basisdurchbruchspannung ist in der Regel nur wenig größer als die Versorgungsspannung V_{DD} und liegt daher optimal für den Einsatz des Schutzeffektes. Durch den Einbau des Bipolartransistors B2 treten keine Substratströme auf, solange der Bipolartransistor B2 nicht in der Sättigung betrieben wird. So wird bei geeigneter Dimensionierung der Transistorgrößen ein "Latch-Up" vermieden. Weiterhin schützt der npn-Bipolartransistor B2 als Klemmelement vor positiven und negativen Überspannungen, wobei die Schutzwirkung in beiden Richtungen knapp außerhalb des Betriebsspannungsbereichs einsetzt. Im nicht eingebauten bzw. nicht angeschlossenen Zustand schützt ein einzelnes so verschaltetes Klemmelement gegen positive und negative Überspannung sowohl bezüglich des positiven als auch des negativen Versorgungsspannungsanschlusses (V_{DD} bzw. V_{SS}), wobei die Schutzwirkung jeweils bei Spannungen einsetzt, die nur knapp über den im Betrieb erlaubten Spannungen liegen.

Figur 4 zeigt eine erste erfindungsgemäße Verschaltung des Bipolartransistors. Hierbei weist der npn-Bipolartransistor B3 zwei Emitter E₁ und E₂, einen Basisanschluß B sowie einen Kollektoranschluß C auf. Die Verschaltung des npn-Bipolartransistors B3 bezüglich des Basisanschlusses B, des Kollektoranschlusses C und des ersten Emitteranschlusses E₁ erfolgt analog wie die Verschaltung des npn-Bipolartransistors B2 nach Figur 2, so daß gleiche Bezugszeichen wie in der Figur 2 hier Verwendung finden. Zusätzlich ist jedoch der npn-Bipolartransistor B3 um ein zweites Emittergebiet E₂ erweitert, wobei durch ein zusätzliches MOS-Gate zwischen den beiden Emittern E₁ und E₂ ein MOS-Transistor MOS entsteht. Wie aus der Figur 4 ersichtlich, wird das zweite Emittergebiet E₂ und der Basisanschluß B an das Bezugspotential V_{SS} (= Masse) und das Gate mit dem zu schützenden Ein- bzw. Ausgang E/A verbunden. Erreicht die Spannung am Ein-bzw. Ausgang E/A die Einsatzspannung des MOS-Transistors, so wird dieser leitend und es fließt ein lateraler Strom über den Source- und Drainanschluß des MOS-Transistors ab. Auch Gatespannungen, die unterhalb der Einsatzspannung liegen, können zu einem Durchbruch (Punch-through) zwischen den beiden Emittern E₁ und E₂ führen und so die Schutzfunktion erfüllen. Die in Figur 5 dargestellten Realisierung des npn-Bipolartransistors B3 entspricht in weiten Teilen der des Bipolartransistors B2 in Figur 3, so daß auch hier wieder die gleichen Bezugszeichen Verwendung finden. Innerhalb der p-leitenden wannenförmigen Halbleiterzone P_{W1} sind jedoch im Gegensatz zu Figur 3 zwei n⁺-dotierte Halbleiteranschlüsse N4 und N5 eingefügt, die jeweils den ersten und zweiten Emitteranschluß E₁, E₂ des npn-Bipolartransistor B3 bilden. Durch ein zusätzliches MOS-Gate G zwischen den Emittern E₁ und E₂ entsteht parallel zum lateralen Bipolartransistor, der sich zwischen dem ersten Emitteranschluß E₁, dem Basisanschluß B und dem zweiten Emitteranschluß E₂ befindet, ein MOS-Transistor. Die Funktion des Klemmelementes aus Figur 4 und Figur 5 entspricht der aus Figur 2 bzw. Figur 3. Im Falle, daß die Spannung am zu schützenden Ein- bzw. Ausgang E/A positiver als das Bezugspotential V_{SS} ist, erzeugen die auftretenden Baissströme am Basisbahnwiderstand innerhalb der p-dotierten Halbleiterzone P1 einen Spannungsabfall, der die Spannung zwischen dem ersten Emitteranschluß E₁ und dem Basisanschluß B bzw. dem Emitteranschluß E₂ erhöht. Die Spannung zwischen den beiden Emittern E₁ und E₂ steigt an, bis es zu einem zusätzlichen Durchbrucheffekt (punch through) zwischen den beiden Emittern E₁ und E₂ kommt. Ein großer Teil des Stromes fließt nun über den zweiten Emitter E2 zum Bezugspotential V_{SS} (= Masse) ab. Dieser Effekt erniedrigt den differentiellen Widerstand des Klemmelements und verbessert die Schutzwirkung. Für positive Überspannungen an den Ein- bzw. Ausgängen E/A wird hierbei der MOS-Feldeffekttransistor MOS gemeinsam mit dem Bipolartransistor B3 eingesetzt, über die ein Abfluß der Überspannung nach der negativen Versorgungsspannungs V_{SS} möglich ist. Gegen negative Überspannung wird in der Verschaltung nach Figur 4 ausschließlich der vorhandene Bipolartransistor B3 genutzt.

Figur 6 zeigt eine zweite erfindungsgemäße Verschaltung eines Bipolartransistors als Klemmelement. In Schutzstrukturen wird meist, wie eingangs bereits erwähnt, zur Strombegrenzung ein Widerstand eingebaut. Realisiert wird dieser Widerstand entweder durch eine Polysiliziumbahn oder durch eine Diffusionsbahn. Polysiliziumbahnen haben den Vorteil, elektrisch isoliert zu sein (kein Substratstrom möglich), sind aber aufgrund der thermischen Isolation weniger belastbar. Diffusionswiderstände in konventioneller CMOS-Technologie erzeugen dagegen einen geringen Substratstrom. Nach Figur 6 ist der Basisanschluß B des npn-Bipolartransistors B4 mit dem Bezugspotential V_{SS} ( = Masse), der Kollektoranschluß desselbigen Transistors mit der Versorgungsspannung V_{DD} verschaltet, während statt eines Emitters wie in Figur 2 zwei Emitteranschlüsse E₁′ und E₂′ vorgesehen sind. Der eindiffundierte Widerstand R ist nach Figur 6 so angeordnet, daß er sich zwischen den beiden Emitteranschlüssen E₁′ und E₂′ befindet. Weiterhin ist der Widerstand R in die zu schützende Ein- bzw. Ausgangsleitung E/A geschaltet, wobei die gesamte Anordnung eine Schutzfunktion erfüllt, wie sie beim herkömmlichen Stand der Technik durch zwei Klemmelemente und einem zwischengeschalteten Widerstand R erreichbar ist. Dies ist besonders deutlich aus der Darstellung in Figur 7 zu entnehmen. Hierbei ist der Aufbau des npn-Bipolartransistors B4 mit integriertem Widerstand R wiedergegeben. Innerhalb des p-dotierten Halbleitersubstrats P_{Sub} ist eine wannenförmige n-leitende Halbleiterzone N_{W1} eingefügt, die den Kollektoranschluß C bildet. Innerhalb dieser n-leitenden Halbleiterzone N_{W1} ist eine zweite p-leitende Halbleiterzone P_{W1} untergebracht, die als Basisanschluß B für den npn-Bipolartransistor B4 dient. Innerhalb dieser wiederum ist eine weitere wannenförmige Halbleiterzone N_{W2} untergebracht, die n⁺-dotiert ist, und an beiden Enden je einen Emitteranschluß E₁′ und E₂′ aufweisen. Wie bereits aus Figur 6 angegeben, erfüllt der npn-Bipolartransistor B4 mit dem Widerstand R die Funktion einer Schutzstruktur mit zwei Klemmelementen und einem diffundierten Bahnwiderstand. Hierbei wird das erste Klemmelement durch die Halbleiterstruktur zwischen dem ersten Emitter E₁′, dem Basisanschluß B und dem Kollektoranschluß C und das zweite Element durch die Halbleiterstruktur zwischen dem zweiten Emitteranschluß E₂′, dem Basisanschluß B und dem Kollektoranschluß C gebildet, während der diffundierte Bahnwiderstand zwischen dem ersten und zweiten Emitteranschluß E₁′, E₂′ vorhanden ist.

Die Erfindung ist für alle Bipolar/CMOS-Technologien mit isolierten Bipolartransistoren unabhängig vom Wannentyp (n- oder p-Wanne; npn- oder pnp-Transistor) und unabhängig von der Art des Bipolartransistors (beispielsweise eines implantierten Bipolartransistors oder Polyemitterbipolartransistors) anwendbar.

## Patentansprüche

1. Bipolartransistor als Schutzelement gegen elektrische Überspannungen für integrierte Schaltungen in einem dotierten Halbleitersubstrat (P_{Sub}) eines ersten Leitungstyps, bei dem ein Basisanschluß (B) mit einer ersten Spannung (V_{SS}), ein Kollektoranschluß (C) mit einer zweiten Spannung (V_{DD}) und ein Emitteranschluß (E) mit einem Ein- oder Ausgang (E/A) der integrierten Schaltung verbunden ist und bei dem der Bipolartransistor in einer ersten Halbleiterzone (N_{W1}) des zweiten Leitungstyps isoliert zur integrierten Schaltung angeordnet ist, **dadurch gekennzeichnet,** daß der Bipolartransistor (B3) einen ersten und einen zweiten Emitteranschluß (E₁, E₂) enthält, daß durch einen zwischen dem ersten und zweiten Emitteranschluß (E₁, E₂) angeordneten Gateanschluß (G) ein MOS-Feldeffekttransistor (MOS) entsteht, daß der Gateanschluß (G) des MOS-Feldeffekttransistors (MOS) und ein erster Emitteranschluß (E₁) mit einem Ein-oder Ausgang (E/A) der integrierten Schaltung und der zweite Emitteranschluß (E₂) mit der ersten Spannung (V_{SS}) verschaltet ist.

2. Bipolartransistor als Schutzelement nach Anspruch 1, **dadurch gekennzeichnet,** daß in dem dotierten Halbleitersubstrat (P_{Sub}) eines ersten Leitungstyps eine wannenförmige Halbleiterzone (N_{W1}) eines zweiten Leitungstyps für den Kollektoranschluß (C) angeordnet ist, die eine Isolierung zwischen dem Bipolartransistor und der integrierten Schaltung bildet, daß in der wannenförmigen Halbleiterzone (N_{W1}) eines zweiten Leitungstyps eine weitere wannenförmige Halbleiterzone (P_{W1}) eines ersten Leitungstyps für den Basisanschluß (B) und in der weiteren wannenförmigen Halbleiterzone (P_{W1}) eines ersten Leitungstyps zwei Anschlüsse (N4, N5) eines höher dotierten zweiten Leitungstyps für den ersten und zweiten Emitteranschluß (E₁, E₂) eingefügt ist, daß oberhalb zwischen dem ersten und zweiten Anschluß (N4, N5) ein Gateanschluß (G) des MOS-Feldeffekttransistors angebracht ist und daß der Gateanschluß (G) durch eine dünne Isolationsschicht von den zwei Anschlüssen und der weiteren wannenförmigen Halbleiterzone (P_{W1}) eines ersten Leitungstyps getrennt ist.

3. Bipolartransistor als Schutzelement gegen elektrische Überspannungen für integrierte Schaltungen mit einem dotierten Halbleitersubstrat (P_{Sub}) eines ersten Leitungstyps, bei dem ein Basisanschluß (B) mit einer ersten Spannung (V_{SS}), ein Kollektoranschluß (C) mit einer zweiten Spannung (V_{DD}) und ein Emitteranschluß (E) mit der Leitung eines Ein- oder Ausgangs (E/A) der integrierten Schaltung verbunden ist und bei der der Bipolartransistor in einer ersten Halbleiterzone (N_{W1}) des zweiten Leitungstyps isoliert zur integrierten Schaltung angeordnet ist, **dadurch gekennzeichnet,** daß der Bipolartransistor (B4) einen ersten und zweiten Emitteranschluß (E₁', E₂') enthält, daß ein Widerstandselement (R) zwischen dem ersten und zweiten Emitteranschluß (E ₁', E₂') angeordnet ist und in die Ein-oder Ausgangsleitung (E/A) der integrierten Schaltung geschaltet ist.

4. Bipolartransistor als Schutzelement nach Anspruch 3, **dadurch gekennzeichnet,** daß in dem dotierten Halbleitersubstrat (P_{Sub}) eines ersten Leitungstyps eine erste wannenförmige Halbleiterzone (N_{W1}) eines zweiten Leitungstyps für den Kollektoranschluß (C) angeordnet ist, die eine Isolierung zwischen dem Bipolartransistor und der integrierten Schaltung bildet, daß in der ersten wannenförmigen Halbleiterzone (N_{W1}) eines zweiten Leitungstyps eine zweite wannenförmige Halbleiterzone (P_{W1}) eines ersten Leitungstyps für den Basisanschluß (B) und in der zweiten wannenförmigen Halbleiterzone (P_{W1}) eines ersten Leitungstyps eine dritte wannenförmige Halbleiterzone (N_{W2}) eines höher dotierten zweiten Leitungstyps für das Widerstandselement (R) mit dem ersten und zweiten Emitteranschluß (E₁', E₂') eingefügt ist.

5. Bipolartransistor als Schutzelement nach Anspruch 2 oder 4, **dadurch gekennzeichnet,** daß der Bipolartransistor ein npn-Bipolartransistor und der MOS- Feldeffekttransistor ein n-Kanal-Feldeffekttransistor ist, daß die Halbleiterzone (P_{W1}) und das Halbleitersubstrat (P_{Sub}) eines ersten Leitungstyps p- und die Halbleiterzonen (N_{W1}, N_{W2}) und Anschlüsse (N3, N4, N5) eines zweiten Leitungstyps n-dotiert sind, und daß die erste Spannung (V_{SS}) kleiner als die zweite Spannung (V_{DD}) ist.

6. Bipolartransistor als Schutzelement nach Anspruch 2 oder 4, **dadurch gekennzeichnet,** daß der Bipolartransistor ein pnp-Bipolartransistor ist, und der MOS-Feldeffekttransistor ein p-Kanal-MOS-Feldeffekttransistor ist, daß das Halbleitersubstrat (P_{Sub}) und die Halbleiterzonen (P_{W1}) eines ersten Leitungstyps n- und die Halbleiterzonen (N_{W1}, N_{W2}) und Anschlüsse (N3, N4, N5) eines zweiten Leitungstyps p-dotiert sind und daß die erste Spannung (V_{SS}) größer als die zweite Spannung (V_{DD}) ist.

## Claims

1. Bipolar transistor as protective element against electrical overvoltages for integrated circuits in a doped semiconductor substrate (P_{Sub}) of a first conduction type, in which a base terminal (B) is connected to a first voltage (V_{SS}), a collector terminal (C) is connected to a second voltage (V_{DD}) and an emitter terminal (E) is connected to an input or output (E/A) of the integrated circuit, and in which the bipolar transistor is disposed in a first semiconductor zone (N_{W1}) of the second conduction type and insulated from the integrated circuit, characterized in that the bipolar transistor (B3) contains a first emitter terminal (E₁) and a second emitter terminal (E₂), in that an MOS field-effect transistor (MOS) is formed by a gate terminal (G) disposed between the first emitter terminal (E₁) and second emitter terminal (E₂), and in that the gate terminal (G) of the MOS field-effect transistor (MOS) and a first emitter terminal (E₁) are connected to an input or output (E/A) of the integrated circuit and the second emitter terminal (E₂) is connected to the first voltage (V_{SS}).

2. Bipolar transistor as protective element according to Claim 1, characterized in that a well-shaped semiconductor zone (N_{W1}) of a second conduction type for the collector terminal (C), which zone forms an insulation between the bipolar transistor and the integrated circuit, is disposed in the doped semiconductor substrate (P_{Sub}) of a first conduction type, in that a further well-shaped semiconductor zone (P_{W1}) of a first conduction type for the base terminal (B) is inserted in the well-shaped semiconductor zone (N_{W1}) of a second conduction type and two terminals (N4, N5) of a more heavily doped second conduction type for the first emitter terminal (E₁) and second emitter terminal (E₂) are inserted in the further well-shaped semiconductor zone (P_{W1}) of a first conduction type, in that a gate terminal (G) of the MOS field-effect transistor is provided above and between the first terminal (N4) and second terminal (N5), and in that the gate terminal (G) is isolated from the two terminals and the further well-shaped semiconductor zone (P_{W1}) of a first conduction type by a thin insulating layer.

3. Bipolar transistor as protective element against electrical overvoltages for integrated circuits having a doped semiconductor substrate (P_{Sub}) of a first conduction type, in which a base terminal (B) is connected to a first voltage (V_{SS}), a collector terminal (C) is connected to a second voltage (V_{DD}) and an emitter terminal (E) is connected to the conductor of an input or output (E/A) of the integrated circuit, and in which the bipolar transistor is disposed in a first semiconductor zone (N_{W1}) of the second conduction type and insulated from the integrator circuit, characterized in that the bipolar transistor (B4) contains a first emitter terminal (E₁') and second emitter terminal (E₂') and in that a resistance element (R) is disposed between the first emitter terminal (E₁') and second emitter terminal (E₂') and is connected in the input or output conductor (E/A) of the integrated circuit.

4. Bipolar transistor as protective element according to Claim 3, characterized in that a first well-shaped semiconductor zone (N_{W1}) of a second conduction type for the collector terminal (C), which zone forms an insulation between the bipolar transistor and the integrated circuit, is disposed in the doped semiconductor substrate (P_{Sub}) of a first conduction type, and in that a second well-shaped semiconductor zone (P_{W1}) of a first conduction type for the base terminal (B) is inserted in the first well-shaped semiconductor zone (N_{W1}) of a second conduction type and a third well-shaped semiconductor zone (N_{W2}) of a more heavily doped second conduction type for the resistance element (R) is inserted, along with the first emitter terminal (E₁') and second emitter terminal (E₂') in the second well-shaped semiconductor zone (P_{W1}) of a first conduction type.

5. Bipolar transistor as protective element according to Claim 2 or 4, characterized in that the bipolar transistor is an n-p-n bipolar transistor and the MOS field-effect transistor is an n-channel field-effect transistor, in that the semiconductor zone (P_{W1}) and the semiconductor substrate (P_{Sub}) of a first conduction type is p-doped and the semiconductor zones (N_{W1}, N_{W2}) and terminals (N3, N4, N5) of a second conduction type are n-doped, and in that the first voltage (V_{SS}) is less than the second voltage (V_{DD}).

6. Bipolar transistor as protective element according to Claim 2 or 4, characterized in that the bipolar transistor is a p-n-p bipolar transistor and the MOS field-effect transistor is a p-channel MOS field-effect transistor, in that the semiconductor substrate (P_{Sub}) and the semiconductor zones (P_{W1}) of a first conduction type are n-doped and the semiconductor zones (N_{W1}, N_{W2}) and terminals (N3, N4, N5) of a second conduction type are p-doped, and in that the first voltage (V_{SS}) is greater than the second voltage (V_{DD}).

## Revendications

1. Transistor bipolaire utilisé en tant qu'élément de protection vis-à-vis de surtensions électriques pour des circuits intégrés dans un substrat semiconducteur dopé (P_{Sub}) et d'un premier type de conductivité, dans lequel une borne de base (B) est placée à une première tension (V_{SS}), une borne de collecteur (C) est placée à une seconde tension (V_{DD}) et une borne d'émetteur (E) est reliée à une entrée ou à une sortie (E/A) du circuit intégré, et dans lequel le transistor bipolaire est disposé, d'une manière isolée par rapport au circuit intégré, dans une première zone semiconductrice (N_{W1}) du deuxième type de conductivité, caractérisé par le fait que le transistor bipolaire (B3) comporte une première et une seconde bornes d'émetteur (E₁, E₂), qu'un transistor à effet de champ MOS (MOS) est formé par une borne de grille (G) disposée entre la première et la seconde bornes d'émetteur (E₁, E₂), que la borne de grille (G) du transistor à effet de champ MOS (MOS) et une première borne d'émetteur (E₁) sont reliées à une entrée ou à une sortie (E/A) du circuit intégré et que la seconde borne d'émetteur (E₂) est reliée à la première tension (V_{SS}).

2. Transistor bipolaire utilisé comme élément de protection suivant la revendication 1, caractérisé par le fait que dans le substrat semiconducteur dopé (P_{Sub}) et d'un premier type de conductivité est disposée une zone semiconductrice en forme de cuvette (N_{W1}) d'un second type de conductivité pour la borne de collecteur (C), cette zone formant une isolation entre le transistor bipolaire et le circuit intégré, qu'une autre zone semiconductrice en forme de cuvette (P_{W1}) d'un premier type de conductivité pour la borne de base (B) est insérée dans la zone semiconductrice en forme de cuvette (N_{W}) d'un second type de conductivité et que deux bornes (N4, N5) d'un second type de conductivité à dopage plus élevé pour la première et la seconde bornes d'émetteur (E₁, E₂) sont insérées dans l'autre zone semiconductrice en forme de cuvette (P_{W1}) d'un premier type de conductivité, qu'une borne de grille (G) du transistor à effet de champ MOS est disposée au-dessus et entre la première et la seconde bornes (N4, N5), et que la borne de grille (G) est séparée, par une couche isolante mince, des deux bornes et de l'autre zone semiconductrice en forme de cuvette (P_{W1}) d'un premier type de conductivité.

3. Transistor bipolaire utilisé comme élément de protection vis-à-vis de surtensions électriques pour des circuits intégrés, comportant un substrat semiconducteur dopé (P_{Sub}) et d'un premier type de conductivité, dans lequel une borne de base (B) est placée à une première tension (V_{SS}), une borne de collecteur (C) est placée à une seconde tension (V_{DD}) et une borne d'émetteur (E) est reliée au conducteur d'une entrée ou d'une sortie (E/A) du circuit intégré, et dans lequel le transistor bipolaire étant disposé, d'une manière isolée par rapport au circuit intégré, dans une première zone semiconductrice (N_{W1}) du second type de conductivité, caractérisé par le fait que le transistor bipolaire (B4) comporte une première et une seconde bornes d'émetteurs (E₁', E₂'), qu'un élément résistif (R) est monté entre la première et la seconde bornes d'émetteur (E₁', E₂') et est branché dans le conducteur d'entrée ou de sortie (E/A) du circuit intégré.

4. Transistor bipolaire utilisé comme élément de protection suivant la revendication 3, caractérisé par le fait qu'une première zone semiconductrice en forme de cuvette (N_{W1}) d'un second type de conductivité pour la borne de collecteur (C) est disposée dans le substrat semiconducteur (P_{Sub}) dopé et d'un premier type de conductivité, cette zone formant une isolation entre le transistor bipolaire et le circuit intégré, qu'une seconde zone semiconductrice en forme de cuvette (P_{W1}) d'un premier type de conductivité pour la borne de base (B) est insérée dans la première zone semiconductrice en forme de cuvette (N_{W1}) d'un second type de conductivité, et qu'une troisième zone semiconductrice en forme de cuvette (N_{W2}) d'un second type de conductivité d'un dopage supérieur pour l'élément résistif (R) est insérée, avec la première et la seconde bornes d'émetteur (E₁', E₂'), dans la seconde zone semiconductrice en forme de cuvette (P_{W1}) d'un premier type de conductivité.

5. Transistor bipolaire utilisé comme élément de protection suivant la revendication 2 ou 4, caractérisé par le fait que le transistor bipolaire est un transistor bipolaire npn et que le transistor à effet de champ MOS est un transistor à effet de champ à canal n, que la zone semiconductrice (P_{W1}) et le substrat semiconducteur (P_{Sub}) d'un premier type de conductivité sont dopés de type p et que les zones semiconductrices (N_{W1}, N_{W2}) et les bornes (N3, N4, N5) d'un second type de conductivité sont dopées du type n, et que la première tension (V_{SS}) est inférieure à la seconde tension (V_{DD}).

6. Transistor bipolaire utilisé en tant qu'élément de protection suivant la revendication 2 ou 4, caractérisé par le fait que le transistor bipolaire est un transistor bipolaire pnp et que le transistor à effet de champ MOS est un transistor MOS à canal p, que le substrat semiconducteur (P_{Sub}) et les zones semiconductrices (P_{W1}) d'un premier type de conductivité sont dopés du type n et que les zones semiconductrices (N_{W1}, N_{W2}) et les bornes (N3, N4, N5) d'un second type de conductivité sont dopées du type p, et que la première tension (V_{SS}) est supérieure à la seconde tension (V_{DD}).
